(19) Europäisches Patentamt
European Patent Office
Office européen des brevets

(11) Publication number: **0 032 878**
**B1**

# (12) EUROPEAN PATENT SPECIFICATION

(45) Date of publication of patent specification: **02.05.85**

(51) Int. Cl.⁴: **H 03 J 7/28**

(21) Application number: **81730008.0**

(22) Date of filing: **19.01.81**

## (54) Radio receiver.

(30) Priority: **21.01.80 JP 4491/80**

(43) Date of publication of application:
**29.07.81 Bulletin 81/30**

(45) Publication of the grant of the patent:
**02.05.85 Bulletin 85/18**

(84) Designated Contracting States:
**BE CH DE FR GB LI NL**

(56) References cited:
**DE-A-2 903 387**
**GB-A-1 553 366**
**US-A-3 968 444**
**US-A-4 077 008**
**US-A-4 114 103**

**FUNKSCHAU, Heft 1, 1979, Franzis-Verlag, München MAX HEGENDÖRFER et al. "Synthesizerabstimmung", pages 5-9**

(73) Proprietor: **FUJITSU-TEN, LTD**
**2-28, Goshodori 1-chome, Hyogo-ku**
**Kobe-shi, Hyogo, 652 (JP)**

(72) Inventor: **Ito, Tatsuo**
**65-306, 1-1, Yokoo 5-chome**
**Suma-ku Kobe-shi Hyogo-ken (JP)**

(74) Representative: **Meinig, Karl-Heinz et al**
**PATENTANWÄLTE-PFENNING-MAAS-MEINIG-SPOTT Kurfürstendamm 170**
**D-1000 Berlin 15 (DE)**

**EP 0 032 878 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The present invention relates to a radio receiver, and more particularly to a radio receiver which is preferably mounted in an automobile.

Generally, there are two ways for conducting a channel selection, the first way is manual channel selection and the second way is automatic channel selection. The latter automatic channel selection is very convenient for conducting a channel selection in an automobile. The reason for this, is that the automobile can always receive broadcasting transmitted from a local broadcasting station which is located in the same area where the automobile is running. Thus, the automatic channel selection is the most preferable way for receiving the corresponding broadcasting being transmitted in the area in which the automobile is running. Of course, local broadcasting can also be received through manual channel selection. in this case, it is relatively easy to realize a circuit for performing automatic channel selection, if the automobile, provided with the circuit, is restricted to run only within a particular area, in which particular area, the frequency range of the broadcasting is relatively limited, as is a MW (medium wave). Contrary to this, it is relatively difficult to realize the above mentioned circuit for performing automatic channel selection, if the automobile, provided with the circuit, runs within a particular area, for example the European Continent. In the European Continent, a LW (long wave) and also a MW are transmitted as AM (amplitude modulation) broadcasting, and further, in some areas, an FM (frequency modulation) broadcasting is also transmitted. In order to deal with such a mixture of broadcastings, during reception of the AM broadcasting, a band switching from the LW to the MW and vice versa, is usually activated by manual operation. In other words, the automatic channel selection cannot be conducted with respect to both bands of the LW and the MW, without operating the above mentioned band changer. Accordingly, if the automatic channel selection is required to be conducted with respect to the LW, the MW and also the FM, three band switching operations, must be carried out, that is the LW-band, the MW-band and the FM-band. Thus, usually, the automatic channel section is conducted in each of the LW, MW and FW bands, independently.

As is apparent from the above, a radio listener would feel convenienced, if the automatic channel selection, during the reception of AM broadcasting, could be done from the LW to the MW and vice versa, without using any manual band switching operation. Also, a radio listener would feel convenienced, if he could conduct the manual channel selection from the LW to the MW and vice versa, without using a manual band switching operation.

In the prior art, a mechanical tuning circuit, comprised of a variable reactance device and a variable capacitance device, is used for conducting the channel selection. However, it is difficult to conduct channel selection, by using a single mechanical tuning circuit, within the range of the LW and MW bands, with a high degree of accuracy. This is because a so-called tracking must be taken into consideration. That is, it is difficult for a radio receiver using the prior art to vary a RF (radio frequency) signal, an IF (intermediate frequency) signal and a LF (local frequency) signal simultaneously with the same linearity, along the LW and MW bands.

Further, regarding the preset buttons, for selecting a desired channel, arranged on an operating panel of the radio receiver, for example, three of the five preset buttons can be allotted to channel selection buttons for selecting desired LW broadcastings and the remaining two preset buttons can be allotted to channel selection buttons for selecting desired MW broadcastings. In such an allocation, it is impossible for a radio listener to tune into one of the desired radio frequencies, at random, by using the above mentioned five preset buttons, without using a manual band switching operation.

In recent years, a so-called PLL (Phase Locked Loop) frequency synthesizer has become being known and put into practical use, and thereby some advantages can be produced, which advantages cannot be produced by the above mentioned mechanical tuning circuit. In other words, a particular radio receiver can be obtained, which particular radio receiver could not be realized by using the mechanical tuning circuit.

From the US—PS 3 968 444 a digital tuning controller is known which comprises a storage means having stored therein codes relating to the location and size of unused or illegal frequency bands. During the tuning operation a counter counts given frequency markers produced by an SWD interferometer. The output signals of the storage means and the counter are applied to the comparing inputs of a digital comparator. According to this citation a search begins upward from the first channel during a tuning operation and continues until an invalid channel is signaled by a coincidence signal generated by the comparator when the content of the counter coincidences with the output state corresponding to the first addressed word of the storage means. When this coincidence occurs the transmission of the information is stopped by inhibiting the counter and the next location in the storage means is addressed. Such location contains a word indicating the number of frequency markers to be skipped. The tuning operation then continues upwards until a coincidence again occurs as signified by the output of comparator. The next location is addressed in the storage means, the counter is freed and the informations are transmitted.

The frequency sweep of the known digital tuning controllers is performed linearly, regardless of existence or nonexistence of illegal bands including no broadcasting therein. Since the tuning operation is performed along the

whole frequency range a quick switching of bands is not possible.

In the present invention, it is intended to realize a particular radio receiver, utilizing the PLL frequency synthesizer, which will satisfy, especially, the following technical matters.

(1) The switching between the LW and MW, can be conducted without using any band switching operation and, accordingly, the two bands of the LW and the MW may substantially be treated as a single band.

(2) Both the preset buttons for the LW, for example, L number of preset buttons, and the preset buttons for the MW, for example, N number of preset buttons (L+N=5 or 7) can be set, at random, without using any band switching operation and, accordingly, it becomes easy for a radio listener to operate the operation panel of the radio receiver.

(3) The automatic channel selection and also the manual channel selection can be conducted between the LW band and the MW band continuously, without using a band switching operation.

It is an object of the present invention to provide a radio receiver, utilizing the PLL frequency synthesizer, which can satisfy the technical matters, mentioned in paragraphs (1), (2) and (3) above. This problem is solved by a radio receiver comprising a LW receiving stage including a LW tuning-amplifying circuit, a LW local oscillating circuit and a LW mixing circuit for converting a LW receiving signal into a LW intermediate frequency signal;

a MW receiving stage including a MW tuning-amplifying circuit, a MW local oscillating circuit and a MW mixing circuit for converting a MW receiving signal into a MW intermediate frequency signaL:

an intermediate frequency controlling stage including a detecting circuit and an intermediate frequency signal detecting circuit, the detecting circuit receives either one of said LW intermediate frequency signals or MW intermediate frequency signals, produced respectively from said LW receiving stage or MW receiving stage, and driving an audio frequency circuit, the intermediate frequency signal detecting circuit operates to detect the appearance of an intermediate frequency signal;

a PLL circuit receiving either a LW local oscillating signal or a MW local oscillating signal, produced respectively from said LW receiving stage or said MW receiving stage and feeding an oscillating output signal, which is specified by an externally supplied digital N value, to said LW tuning-amplifying circuit or MW tuning-amplifying circuit via respective feed back paths; and

a digital N value generating circuit producing said digital N value, a first storage means storing both the lowest frequency $f_{Lmin}$ and the highest frequency $f_{Lmax}$ of a LW receiving frequency range and also both the lowest frequency $f_{Mmin}$ and the highest frequency $f_{Mmax}$ of the MW receiving frequency range, a sweep controlling means for increasing or decreasing said digital N value of said digital N value generating circuit by one integer upwardly or downwardly, a comparing means for receiving, at its first comparing input, said digital N value and for receiving, at its second comparing input, either one of the values $f_{Lmin}$ and $f_{Lmax}$ or either one of the values $f_{Mmin}$ and $f_{Mmax}$, using a LW/MW discriminating means for receiving said digital N value and discriminating whether the digital N value specifies the LW or the MW, further designating either said values $f_{Lmin}$ and $f_{Lmax}$ or said values $f_{Mmin}$ and $f_{Mmax}$ according to the result of said discriminating operation, furthermore energizing either said LW receiving stage or said MW receiving stage, a second storage means, acting as a storage means for achieving transmission of the initial set of data regarding said frequencies $f_{Lmin}$, $f_{Lmax}$, $f_{Mmin}$ and $f_{Mmax}$ to said digital N value generating circuit, for receiving, from said first storage means, the other of said values $f_{Lmin}$ and $f_{Lmax}$ or the other of said values $f_{Mmin}$ and $f_{Mmax}$, which values are stored in said first storage means, but not applied to said comparing means; and

in the sweep controlling means, when the upward sweeping of said digital N value is to be conducted, said values $f_{Lmax}$ and $f_{Lmin}$, during the LW band, and said values $f_{Mmax}$ and $f_{Mmin}$, during the MW band, are supplied, from said first storage means, respectively to said comparing means, at said second comparing input and said second storage means, the band switching operation, between the LW band and the MW band, is carried out every time a coincidence signal is produced from said comparing means, while also in the sweep controlling means, when the downward sweeping of said digital N value is to be conducted, said values $f_{Lmin}$ and $f_{Lmax}$, during the LW band, and said values $f_{Mmin}$ and $f_{Mmax}$, during the MW band, are supplied, from said first storage means, respectively to said comparing means, at said second storage means, the band switching operation, between the LW band and the MW band, is carried out every time the coincidence signal is produced from said comparing means.

Embodiments of the present invention will now be described, by way of example, with reference to the accompanying drawings, in which:

Fig. 1 depicts a graph, used for explaining the operation of a radio receiver according to the present invention;

Fig. 2 is a flowchart for conducting an automatic channel selection or a manual channel selection;

Fig. 3 is a flowchart for conducting a preset (digital) channel selection by using preset buttons;

Fig. 4 is a block diagram of a radio receiver, according to the present invention, which is constructed by using hardware;

Fig. 5 is a front view of an operating panel which is used in the radio receiver, according to the present invention, and;

Fig. 6 is a detailed block diagram of the circuit

shown in Fig. 4, according to the present invention.

Fig. 1 depicts a graph, used for explaining the operation of a radio receiver according to the present invention. In the graph of Fig. 1, the abscissa indicates a time (t) and the ordinate indicates a frequency (f). The symbol RLW denotes a frequency range of the LW, the lowest frequency of the RLW is represented by the symbol $f_{Lmin}$, for example 155 kHz, and the highest thereof is represented by the symbol $f_{Lmax}$, for example 281 kHz. In this case, the frequency $f_{Lmin}$ and the frequency $f_{Lmax}$ correspond, regarding digital N values of the PLL frequency synthesizer, respectively to N=67 and N=81. Similarly, the symbol RMW denotes a frequency range of the MW, the lowest frequency of the RMW is represented by the symbol $f_{Mmin}$, for example 522 kHz, and the highest frequency thereof is represented by the symbol $f_{Mmax}$, for example 1602 kHz. In this case, the frequency $f_{Mmin}$ and the frequency $f_{Mmax}$ correspond, regarding said digital N values of the PLL frequency synthesizer, respectively to N=108 and N=228.

When automatic channel selection or manual channel selection (semi-automatic channel selection) is conducted, a receiving frequency can be varied along a route indicated by solid line arrows such as

$$f_{Lmin} \rightarrow f_{Lmax} \Rightarrow f_{Mmin} \rightarrow f_{Mmax} \Rightarrow f_{Lmin} \rightarrow - - - ,$$

by sweeping a local oscillating frequency upwardly, thereby a desired broadcasting of all those which are being received can be selected. (Note: the above mentioned term "semi-automatic channel selection" means a selection mode in which, when a selection button is turned/pressed ON, an automatic sweep is operated, while, when the selection button is OFF, the automatic sweep is stopped; the above symbol "$\Rightarrow$" denotes that the receiving frequency changes stepwise from the LW to the MW and vice versa). Contrary to the above, the receiving frequency can be varied along a route indicated by dotted line arrows such as

$$f_{Mmax} \rightarrow f_{Mmin} \Rightarrow f_{Lmax} \rightarrow f_{Lmin} \Rightarrow f_{Mmax} \rightarrow - - -$$

by sweeping the local oscillating frequency downwardly, thereby a desired broadcasting of all those which are being received can be selected. Especially, according to the automatic channel selection mode, every time each of the broadcastings is correctly received during the sweep of the above mentioned route, indicated by the solid line arrow or the dotted line arrow, the sweep is suddenly stopped. This automatic channel selection can be operated by means of a circuit for detecting the appearance of an intermediate frequency signal or another circuit for detecting the appearance of a broadcasting signal. However, according to the manual channel selection mode, the sweep is suddenly stopped at the moment when a radio listener stops operating the manual channel selection, regardless of an appearance of a broadcasting signal. On the other hand, according to the automatic or semi-automatic channel selection mode, a radio listener can catch a desired radio frequency signal, at will, by turning the above mentioned selection button OFF.

In the prior art, when each frequency transition occurs, such as $f_{Lmax} \Rightarrow f_{Mmin}$, $f_{Mmax} \Rightarrow f_{Lmin}$, $f_{Mmin} \Rightarrow f_{Lmax}$ or $f_{Lmin} \Rightarrow f_{Mmax}$, it is required to conduct the manual band switching operation. However, in the radio receiver according to the present invention, it is not required to conduct such a manual band switching operation. Further, in the prior art, there are five or seven preset buttons, in which some of the preset buttons are allotted to selecting the LW channels and the remaining preset buttons are allotted to selecting the MW channels. In this case, each preset button is restricted to the LW channel only or a preset button for the MW channel only, due the mechanism of the preset buttons. However, since the number of the LW stations and the number of the MW stations change in every country or area, it is not convenient for a radio listener to divide the preset buttons only into the LW and MW preset buttons. Furthermore, in the prior art, although the same preset button can be allotted to the LW or the MW alternatively, by conducting the band switching operation, such mechanism will become complicated if a preset button must also be allotted to FM besides the LW and the MW.

However, the above mentioned band switching operation will be eliminated from the radio receiver, by introducing the PLL frequency synthesizer into the radio receiver and, accordingly, both the LW band and MW band can be treated substantially as a single band. Based on the above mentioned conception, the radio receiver of the present invention operates by the steps defined by flowcharts shown in Figs. 2 and 3. Fig. 2 is a flowchart for conducting an automatic channel selection or a manual channel selection. Fig. 3 is a flowchart for conducting a preset (digital) channel selection by using preset buttons. In Fig. 2, first, an automatic channel selection button is turned ON (see step ⓐ: "AUTOMATIC CHANNEL SELECTION BUTTON IS SWITCHED ON"). In this case, the sweep is designated to shift upwardly along the solid line arrows shown in Fig. 1. Next, it is determined whether or not the digital N value designates the LW, where the digital N value is produced from a digital N value generator and applied to a PLL circuit (see step ⓑ: "DOES N VALUE DESIGNATE LW?"). That is, in step ⓑ, it is discriminated whether the present N value exists within the receiving frequency range of the RLW or the RMW (refer to Fig. 1). If the N value exists within the range of the RLW (see "YES"), step ⓒ starts. In step ⓒ, it is detected whether or not the N value designates the highest frequency ($f_{Lmax}$) of the LW (see step ⓒ: "DOES N VALUE DESIGNATE $f_{Lmax}$?"). That is, it is determined whether the

present N value exists at the highest frequency of the receiving frequency range of the RLW (see Fig. 1) or exists in below of this highest frequency. If the N value does not yet reach the highest frequency ($f_{Lmax}$) (see "NO" of step ⓒ, the N value is increased by one step and thus the higher receiving frequency signal is selected (see step ⓓ: "N→N+1"). At this increased frequency, it is detected whether or not a radio broadcasting exists (see step ⓔ "DOES RADIO BROADCASTING EXIST?"). If the radio broadcasting exists (see "YES" of step ⓔ), the above mentioned circuit for detecting the intermediate frequency signal, is operated and the automatic channel selection operation is stopped (see step ⓕ: "STOP AUTOMATIC CHANNEL SELECTION"). At this moment, if the received radio broadcasting is comfortable for the radio listener, the automatic channel selection mode is released (see step ⓖ: "END"). If not, he will put the automatic channel selection button ON again, and the operation will return to the first step ⓐ.

At step ⓔ, if it is determined that no radio broadcasting exists, then it is detected whether or not the present N value designates the MW (see step ⓗ: "DOES N VALUE DESIGNATE MW?"). Since the channel selection of the RLW (Fig. 1) is being conducted at present, the result of step ⓗ should be "NO". Therefore, the operation starts again from step ⓒ. Thereafter, the increment from N to N+1 of step ⓓ will be executed repeatedly until the receiving frequency, obtained by the channel selection, reaches the highest frequency of the RLW. In step ⓒ, if it is determined that the N value now designates the MW (see "YES" of step ⓒ), this means that since the N value reaches the highest limit of the RLW (Fig. 1), the band must be switched from the LW to the MW (see step ⓘ: "SWITCHING TO MW"). This switching from the LW to the MW, is carried out not by the manual band switching operation but by the automatic band switching operation which is automatically conducted by a change of the N value and also a LW/MW band switching signal. The above mentioned change of the N value is carried out, in the present stage, by setting the $f_{Mmin}$ as a new N value (see step ⓙ: "SET N VALUE to $f_{Mmin}$").

Next, the operation returns to step ⓔ again and if, in this step, MW radio broadcasting is received, the automatic channel selection operation is stopped at step ⓕ. If the received radio broadcasting satisfies the radio listener, step ⓖ (END) takes place. If not, he will turn the automatic channel selection button ON again, and the operation will return to the first step ⓐ.

Contrary to the above, in step ⓔ, if MW radio broadcasting is not received, the result of step ⓔ is "NO" and then step ⓗ starts. Since channel selection of the RMW (Fig. 1) is being conducted at present, the result of step ⓗ should be "YES". Thereafter, step ⓚ ("N→N+1") starts, in order to seek, step by step, a radio broadcasting having the higher receiving frequency. This digital N value is increased one by one until a comfortable radio broadcasting is received, along the following steps step ⓚ→step ⓔ' ("DOES RADIO BROADCASTING EXIST?")→step ⓛ ("DOES N VALUE DESIGNATE $f_{Mmax}$?")→the step ⓚ. If MW radio broadcasting is received, the result of step ⓔ' becomes "YES", the automatic channel selection operation is stopped at step ⓕ. If the received MW radio broadcasting is satisfactory for the radio listener, the operation reaches step ⓖ (END). If not, the automatic channel selection button is turned ON again at step ⓐ.

Since the receiving frequency exists within the range of the RMW (Fig. 1), the result of step ⓑ becomes "NO", and then step ⓛ starts (see step ⓛ: "DOES N VALUE DESIGNATE $f_{Mmax}$?"). If the present N value still designates a receiving frequency existing within the range of the RMW, the result of step ⓛ is "NO". Therefore, the operation is oriented to the above mentioned step ⓚ. Thereafter, it goes through the following steps: step ⓔ'→step ⓛ→step ⓚ→step ⓔ', and flows again until a comfortable radio broadcasting is received.

The channel selection in the RMW is continued and when the receiving frequency reaches the $f_{Mmax}$, the result of step ⓛ becomes "YES". Thereafter, step ⓜ starts (see step ⓜ: "SWITCHING TO LW"). This switching from the MW to the LW is also, as previously mentioned, carried out not by a manual band switching operation but by the automatic band switching operation which is automatically conducted by the change of the N value and also the LW/MW band switching signal. The above mentioned change of the N value is carried out, in the present stage, by setting the $f_{Lmin}$ as a new N value (see step ⓝ: "SET N VALUE TO $f_{Lmin}$"). Thus the receiving frequency is changed again to a frequency of the RLW, and identical operations as previously mentioned, will be carried out repeatedly.

The above explanation has been made by taking as an example of the case where the sweep is conducted upwardly along the solid line arrows of Fig. 1. Contrary to this, if the sweep is conducted downwardly along the dotted line arrows of Fig. 1, similar automatic channel selection as previously mentioned can be conducted by carrying out reverse sequences with respect to the above explained sequences. For example, step ⓑ should be changed to read as "DOES N VALUE DESIGNATE MW?", step ⓒ should be changed to read as "DOES N VALUE DESIGNATE $f_{Mmin}$?", step ⓓ should be changed to read as "N→N−1", step ⓗ should be changed to read as "DOES N VALUE DESIGNATE LW?", step ⓘ should be changed to read as "SWITCHING TO LW", step ⓙ should be changed to read as "SET N VALUE TO $f_{Lmax}$", step ⓚ should be changed to read as "N→N−1", step ⓛ should be changed to read as "DOES N VALUE DESIGNATE $f_{Lmin}$?", step ⓜ should be changed to read as "SWITCHING TO MW" and step ⓝ should be changed to read as "SET N VALUE to $f_{Mmax}$".

In Fig. 3, which is a flowchart for conducting a preset channel selection by using preset buttons

first, the preset button is switched on at step ⓞ. In the next step ⓟ, it is determined whether or not the preset button, being now turned ON, selects the LW radio broadcasting (see step ⓟ: "DOES N VALUE DESIGNATE LW?"). If the preset button indicates selection of a LW radio broadcasting ("YES"), the tuning circuit of the radio receiver is switched to the LW tuning status by a command of the LW/MW band switching signal (see step ⓠ: "SWITCHING TO LW") and also the N value designated by the preset button is set (see step ⓡ: "SET N VALUE"). Thus, the LW band radio broadcasting can be received, which is designated by the preset button (see step ⓢ: "RECEIVING OF BROADCASTING").

Contrary to the above, in step ⓟ, if it is determined that the N value designates the MW (see "NO" of step ⓟ), a step ⓣ starts. In step ⓣ, the operation of "SWITCHING TO MW" is carried out by the LW/MW band switching signal and, further, in step ⓤ, the operation "SET N VALUE" is carried out and finally the desired MW band radio broadcasting can be received at step ⓢ.

In the flowchart of Fig. 3, the above mentioned determination in step ⓟ, the band switching in step ⓠ and the band switching in step ⓣ, are carried out automatically in the radio receiver (explained hereinafter).

The operations, conducted according to the flowcharts of Figs. 2 and 3, can be processed mainly with the aid of a micro-computer, under control of software. That is, programs are set up, in advance, according to the above mentioned steps and, thus, the radio receiver can be controlled under these programs.

It is, of course, possible that the operations, conducted according to the flowcharts of Figs. 2 and 3, can also be performed mainly by hardware, that is, by electronic circuits.

Fig. 4 is a block diagram of a radio receiver, according to the present invention, which is constructed by hardware. In this figure, the symbol ANT denotes an antenna for receiving radio broadcasting, the symbol SP denotes a speaker which transmits the radio broadcasting frequency signal as an audio signal. A block 10, connected between the antenna ANT and the speaker SP, is a conventional part of a radio receiver circuit. (Note: Circuits, acting as the FM receiving part of the radio receiver, are omitted from this figure). Therefore, circuits, located outside the block 10, are newly employed according to the present invention.

First, an input signal from the antenna ANT, is applied to a LW receiving stage 20 or a MW receiving stage 30. The LW receiving stage 20 and the MW receiving stage 30 are alternatively energized by a battery B, by way of a power switching circuit 51. Accordingly, when the LW receiving stage 20 is in an active status, the MW receiving stage 30 is left in an idle status, and vice versa. Either an LW intermediate frequency signal, from the LW receiving stage 20, or an MW intermediate frequency signal, from the MW receiving stage 30, is led, via an OR circuit 11, to an intermediate frequency control stage 40 and finally reaches, via an audio frequency circuit (AF) 12, the speaker SP.

The LW receiving stage 20 is comprised of an LW tuning-amplifying circuit (LW/RF) 21, an LW local oscillating frequency circuit (LW/LO) 22 and an LW mixing circuit (LW/MIX) 23, the circuit 23 mixes the frequency of the output signal from the circuit 21, with the frequency of the output signal from the circuit 22.

The MW receiving stage 30 is comprised of an MW tuning-amplifying circuit (MW/RF) 31, an MW local oscillating frequency circuit (MW/LO) 32 and an MW mixing circuit (MW/MIX) 33, the circuit 33 mixes the frequency of the output signal from the circuit 31, with the frequency of the output signal from the circuit 32.

The intermediate frequency controlling stage 40 is comprised of an intermediate frequency amplifying circuit (IF) 41, which amplifies the intermediate frequency output signal from the OR circuit 11, a detecting circuit (DET) 42 which detects the intermediate frequency signal developed at the output of the circuit 41, and an intermediate frequency signal detecting circuit (IF/DET) 43, which detects the appearance of the above mentioned intermediate frequency signal.

An LW local oscillating frequency signal SLL, from the circuit 22, or an MW local oscillating frequency signal SLM, from the circuit 32, is applied, via an OR gate 13, to a PLL circuit 14. The circuit 14 receives either the signal SLL or the signal SLM and also the digital N value data $D_N$, supplied as external data, thereby the so-called frequency synthesizer is formed by the PLL circuit 14. That is, the circuit 14 contains therein a crystal oscillator $X_{ta1}$ and produces an oscillating output signal, the frequency of which signal is determined by the N value which is designated by the data $D_N$, the circuit 14 thereby maintains a stable phase locked loop through a low pass filter (LPF) 15→the local oscillating frequency circuit 22 (or 32)→the OR gate 13→the PLL circuit 14→the low pass filter (LPF) 15. In this case, during the stable status condition of the phase-locked loop, the following equation,

$$f_{SLL}=N \cdot f_r$$

or

$$f_{SLM}=N \cdot f_r$$

is obtained, where $f_{SLL}$ and $f_{SLM}$ denote respectively the frequencies of the above mentioned signals SLL and SLM, N denotes the digital N value ($D_N$) and fr denotes the frequency of a reference signal, for example 9 kHz. The frequency of 9 kHz corresponds to a minimum separation frequency, by which frequency a plurality of radio broadcasting frequencies, existing in the ranges of the RLW and the RMW in fig. 1, can be differentiated from one another.

The explanations, mentioned above, are effected only on typical and conventional parts of the radio receiver circuit in fig. 4. The circuit according to the present invention will now be

explained. The major part of the circuit according to the present invention in fig. 4 is comprised of a comparing circuit 52, a first storage circuit 53, a digital N value generating circuit 54, a channel selecting circuit 55, including a second storage circuit therein, and an operating panel 56. The operating panel 56 is provided with a plurality of operating buttons, for example as shown in Fig. 5. Fig. 5 is a front view of an operating panel which is used in the radio receiver, according to the present invention. In Fig. 5, the symbol PB represents preset buttons which can select, for example seven channel radio broadcasts. The symbol AT represents an automatic channel selection button for starting the sweep of the automatic channel selection upwardly. The symbol AT' represents an automatic channel selection button for starting the sweep of the automatic channel selection downwardly. The symbol MT represents a manual channel selection knob. When the knob is rotated clockwise, the sweep of the manual channel selection starts upwardly, while, rotated counterclockwise, the sweep thereof starts downwardly. The symbol VD represents a knob for a volume control. It should be noted that, instead of the above mentioned knob, momentary-type pushbuttons can also be utilized. For example, when a momentary-type push-button (VD) is pressed ON, the sweep of the manual channel selection may be started upwardly, and alternatively, when a momentary-type push-bution (MT) is pressed ON, the sweep thereof may be started downwardly. In this case, either one of the pushbuttons (VD, MT) may be cancelled, if necessary. The symbol BS represents a band switching button which performs band switching between the AM (LW, MW) and the FM. In this case, the band switching between the LW and the MW is, as previously mentioned, not required. A display panel DP indicates what band is now selected and what receiving frequency is now selected. The symbol MB represents a memory button. The memory button MB is used when respective desired radio broadcasts are initially allotted to respective preset buttons PB.

Returning again to Fig. 4, when the operations, defined by the flowchart of Fig. 3, are carried out, a desired one of the preset buttons (PB) on the panel 56, is placed ON. Then, the digital N value, corresponding to this desired preset button PB, is produced from the channel selection circuit 55 and set in the digital N value generating circuit 54. The circuit 54 provides the data $D_N$, corresponding to the N value, to the PLL circuit 14. As a result, a desired radio broadcast, designated by the corresponding preset button, can be received.

On the other hand, in Fig. 4, when the operations, defined by the flowchart of Fig. 2, are carried out, first the gist of the step ⓐ is conducted by the operating panel 56 and the gist of the step ⓑ is conducted by means of an LW/MW discriminating circuit (although which the circuit is contained in the channel selection circuit 55, but is not illustrated in Fig. 4) which controls the power switching circuit 51. The gist of step ⓒ is conducted by means of the circuit 52. The gist of step ⓓ is conducted by means of the circuit 54. The circuit 54 receives clock signal CLK from the circuit 14 and carries out the increment operation of the N value, that is $N \rightarrow N+1$. The gist of step ⓔ is conducted in accordance with the condition whether or not a signal SID is generated from the circuit 43. When the signal SID is applied to the circuit 54, the circuit 54 stops receiving the clock signal CLK. The gist of step ⓗ is conducted by means of the aforesaid LW/MW discriminating circuit, but is not shown in Fig. 4. The gist of step ⓘ is conducted by means of said LW/MW discriminating circuit which controls the circuit 51. The gist of step ⓙ is conducted by transferring data from the circuit 53 to the circuit 54. The gist of step ⓚ is conducated by means of the circuit 54, as is also step ⓓ. The gist of step ⓛ is conducted by means of the circuit 52. The gist of step ⓜ is conducted by means of said LW/MW discriminating circuit which controls the circuit 51. The gist of step ⓝ is conducted by transferring data from the circuit 53 to the circuit 54.

Fig. 6 is a detailed block diagram of the circuit shown in Fig. 4, according to the present invention. The OR gate 13, the PLL circuit 14 and the low pass filter (LPF) 15, shown in Fig. 6, are identical to those shown in Fig. 4. The OR gate 13 receives the signals SLL and SLM and also receives a local oscillating frequency signal SLF of the FM, if necessary. In the upward sweeping automatic channel selection button 64-4 (see the AT of Fig. 5) is placed ON and a corresponding one of flip · flops, in a flip · flop array circuit 63, is set. An output from the flip · flop is applied, via a line 101, to a sweep control circuit 62. Then, an up(increment)-control signal is applied, via a line 102, to the up(increment)-control input of each 4-bit programmable up/down counters 66-1, 66-2, 66-3 and 66-4. Thereafter, these counters 66-1 through 66-4 act as an up(increment)-counter. It should be noted that the counters 66-1 through 66-4 correspond to the digital N value generating circuit 54 of Fig. 4. The N value, corresponding to the lastly used receiving frequency, is set into the counters 66-1 through counter 66-4, via respective lines 103, 104, 105 and 106, where the lastly used receiving frequency has been stored in a second storage circuit 67. The above mentioned setting of the digital N value is carried out when a load command signal is applied from the circuit 67, via a line 107, to each of the counters. The lastly used receiving frequency can be held as it is, because the corresponding lastly used N value, held in respective counters 66-1 through 66-4, is transferred, via a line 108, to the second storage circuit 67 and the circuit 67 is maintained to be active by not stopping the supply of power thereto. In order to realize this, the power from the battery +B is always supplied, via a line 109, to the circuit 67. On the other hand, the power from the battery +B is supplied to the circuit block 10 of Fig. 4 via a switch which is connected in series with the battery +B. Accordingly, the circuit block 10 can

be active or non-active by controlling this switch. In this case, the second storage circuit 67 can be made of a RAM (Random Access Memory) which corresponds to circuit 55 of Fig. 4.

An LW/MW discriminating circuit 78 is employed so as to detect whether the N value, held in the counters 66-1 through 66-4, designates the LW or the MW (refer to step ⓑ of Fig. 2). The circuit 78 can be realized very simply, if a particular fact is taken into consideration. That is, during the LW status, the N value is within the range of 67~81, while, during the MW status, the N value is within the range of 108~228. According to this fact, during the LW status, a logic bit "0" is developed on a line 111 connecting with the counter 66-3, while, during the MW status, a logic bit "1" or "0" is developed on the same line. Accordingly, the LW and the MW can be distinguished from each other by supervising a logic bit "0" or "1" developed on the line 111, with the aid of, for example a two-input OR gate. The output bit of the counter 66-1 corresponds to a LSB (Least Significant Bit) and the output bit of the counter 66-4 corresponds to a MSB (Most Significant Bit).

Whether or not the N value, held in the counters 66-1~66-4, designates the LW or the MW, can be determined by means of the circuit 78. The determination by the circuit 78 is transferred to a first storage circuit (corresponding to circuit 53 of Fig. 4) and a power switching circuit 79 (corresponding to circuit 51 of Fig. 4). The circut 79 distributes a power PLW to be supplied to the LW circuit group or a power PMW to be supplied to the MW circuit group alternatively in accordance with the instruction from the circuit 78. If the circuit discriminates that the LW band is now selected (refer to "YES" of step ⓑ in Fig. 2), the first storage circuit 73 (corresponding to circuit 53 of Fig. 4) produces data indicating the highest frequency $f_{Lmax}$ of the LW, and supplies the data ($f_{Lmax}$) to a comparing input (II) of a comparing circuit 72. The circuit 72 can be made of a so-called digital comparator. The circuit 73 can be made of a ROM (Read Only Memory), and further the circuit 78 also stores, other than the above mentioned data indicating the highest frequency $f_{Lmax}$ of the LW, data indicating the lowest frequency $f_{Lmin}$ of the LW, data indicating, respectively the highest and lowest frequencies $f_{Mmax}$ and $f_{Mmin}$ of the MW.

As mentioned above, the data, indicating the highest frequency $f_{Lmax}$ of the LW, is now fixedly applied to the second comparing input (II) of the comparing circuit 72, and simultaneously the N value of the counters 66-1~66-4 is applied to the first comparing input (I) of the circuit 72. This N value is increased one by one (refer to step ⓓ in fig. 2) under the upward sweeping automatic channel selection mode, if the button AT of Fig. 5 is placed ON. The N value, defined by the counters 66-1~66-4 can increase one by one, because these counters receive, via a line 112, a clock signal CLK (refer to the CLK of Fig. 4) supplied from a sweep controlling circuit 62. In this case, the clock signal CLK can be produced by dividing the high frequency clock signal, given from the PLL circuit 14, into a clock signal having the frequency of, for example 9 kHz, by means of a frequency dividing circuit 61. Thus, the counters 66-1~66-4 can increase their N value one by one, by receiving successive clock signals CLK (refer to step ⓓ in Fig. 2). The N value, increasing successively, is applied, as N value data $D_N$, to the PLL circuit 14 successively via a data selector 65. In this case, the N value of the counters 66-1~66-4 is supplied from the data selector 65 to the PLL circuit 14 synchronous with a clock signal given, via a line 113, from the frequency dividing circuit 61. This synchronization is necessarily obtained, because the clock signal, on the line 113, is produced synchronous with the clock signal on the line 112.

As explained above, the LW receiving stage 20 of Fig. 4 can sweep the receiving frequency range RLW successively by means of the PLL circuit 14. During this sweep of the receiving frequency, it is detected whether or not the radio broadcasting exists (refer to step ⓔ in Fig. 2). If a radio broadcast is received, the intermediate frequency detecting signal SID is produced from the intermediate frequency detecting circuit 43 of Fig. 4 and applied, in Fig. 6, to the flip · flop array circuit 63. At the same time, the flip · flop, connecting with the upward sweeping automatic channel selection button 64-4, is reset and, accordingly the sweep controlling circuit 62 is de-energized by a signal transferred on the line 101. Consequently, the counters 66-1~66-4 are also de-energized and left as they are. Thus, the last N value of these counters is held as it is (refer to step ⓕ in Fig. 2). As a result, the radio broadcast on the LW band, specified by the last N value, can be received.

During the successive increase of the N value, by the counters 66-1~66-4, if no radio broadcast is received (refer to "NO" step ⓔ in Fig. 2), then step ⓗ in Fig. 2 starts. In step ⓗ, if the LW/MW discriminating circuit 78 of Fig. 6 determines that the N value of the counters 66-1~66-4 designates the LW band, then step ⓒ in Fig. 2 is started again Step ⓒ is conducted mainly by the comparing circuit 72 of Fig. 6. As previously explained, since the circuit 72 now receives, at its second comparing input (II), the highest frequency $f_{Lmax}$ of the LW band, the N value of the counters 66-1~66-4, applied to the first input (I) thereof, is compared with the frequency $f_{Lmax}$ with respect to a large or small relationship therebetween. When the N value of the counters becomes equal to the N value designating the frequency $f_{Lmax}$, it is concluded that the receiving frequency reaches the highest border of the range RLW shown in Fig. 1 (refer to "YES" of step ⓒ in Fig. 2). At this time, the comparing circuit 72 produces a coincidence signal and applies this signal, via a line 114, to the circuit 73. Then, the circuit 73 writes data, indicating the lowest frequency $f_{Mmin}$ of the MW stored therein, into the second storage circuit 67 via a line 115. The write operation of the data ($f_{Mmin}$) is achieved in accordance with an

instruction given by a read/write controlling circuit 71. The data ($f_{Mmin}$), written in the circuit 67, is set into the counters 66-1~66-4 via lines 103~106. Accordingly, the N value of the counters 66-1~66-4 is changed to the N value indicating the frequency $f_{Mmin}$. At this time, the circuit 78 detects the occurrence of band switching from the LW to the MW, by the signal transferred on line 111, and the circuit 78 instructs the circuit 79 to supply the power PMW to be supplied to the MW receiving stage 30 of Fig. 4. At this moment, the receiving frequency exists at the starting point of the frequency range RMW in Fig. 1.

On the other hand, when the comparing circuit 72 produces the above mentioned coincidence signal on the line 114, the circuit 73 applies data, indicating the highest frequency $f_{Mmax}$ of the MW band stored therein, to the second comparing input (II) of the circuit 72. In this case, when the receiving frequency is within the range of the RMW in Fig. 1, the circuit 72 fixedly receives, at its second comparing input (II), the data indicating the frequency of $f_{Mmax}$.

At present, since the band switching from the LW to the MW is performed, the result of step ⓑ in Fig. 2 is now "NO" and, accordingly step ⓛ starts. The result "NO" of step ⓛ is held as it is until the N value of the counters 66-1~66-4 reaches the N value corresponding to the frequency of $f_{Mmax}$. During this time, the circuit 72 cannot still produce the aforesaid coincidence signal therefrom. Therefore, step ⓚ in Fig. 2 is conducted. Since the upward sweeping automatic channel selection button 64-4 is now pressed ON, the flip · flop array circuit 63 signals to the sweep controlling circuit 62 and the circuit 62 controls, so as to make the counters 66-1~66-4 as the up(increment)-counter which is driven by the clock signal CLK. Therefore, the N value of the counters 66-1~66-4 increases one by one from the N value corresponding to the frequency $f_{Mmin}$ (refer to step ⓚ in Fig. 2). If the intermediate frequency detecting signal SID is produced from the circuit 43 of Fig. 4 and applied to the circuit 63 of Fig. 6, the corresponding flip · flop of the circuit 63 is reset. Accordingly, the sweep controlling circuit 62 is de-energized and, then the counters 66-1~66-4 stop counting the clock signal CLK and hold the last N value thereof as it is (refer to "YES" of step ⓔ' in Fig. 2). If the received radio broadcast is not satisfactory for a radio listener, he places the button 64-4 ON again and starts step ⓐ in Fig. 2 again. When the N value of the counters 66-1~66-4 reaches the N value indicating the frequency of $f_{Mmax}$, the values of the first and second comparing inputs of the comparing circuit 72 coincide with each other, and then, the coincidence signal is applied to the circuit 73 via the line 114 (refer to "YES" of step ⓛ in Fig. 2). Thereafter, the circuit 73 writes the data, indicating the frequency of $f_{Lmin}$ stored therein, into the circuit 67 via the line 115. Further, this N value, indicating the frequency $f_{Lmin}$, is set into the counters 66-1~66-4 (refer to step ⓝ in Fig. 2). At this time, the line 111 provides the logic bit "O" and, accordingly, the power PLW to be supplied to the LW receiving stage 20 is fed from the battery +B by means of the circuits 78 and 79. As a result, the band switching from the MW to the LW is automatically achieved (refer to step ⓜ in Fig. 2). Also, at this time, the circuit 73 receives the aforesaid coincidence signal via the line 114 and applies the data, indicating the frequency of $f_{Lmax}$, to the second comparing input (II) of the comparing circuit 72, fixedly. Thus, the sweep of the frequency begins from the starting point of the range RLW in Fig. 1. In the above mentioned operational sequence, step ⓜ and ⓝ take place simultaneously and also steps ⓘ and ⓙ take place simultaneously.

The above mentioned operational sequence is performed by taking as an example a case in which the upward sweeping automatic channel selection button 64-4 is pressed ON. Contrary to this, when the downward sweeping automatic channel selection mode is selected the button 64-3 should be ON. In this case, the counters 66-1~66-4 are controlled to operate as a down-(decrement)-counter, by a signal transferred via the line 101, the circuit 62 and the line 102. Further, when the comparing circuit 72 produces the aforesaid coincidence signal, the circuit 73 supplies data, indicating the lowest frequency of $f_{Lmin}$ (RLW) or $f_{Mmin}$ (RMW), to the circuit 72, at its second comparing input II, while, the circuit 73 also supplies data, indicating the highest frequency of $f_{Lmax}$ (RLW) or $f_{Mmax}$ (RMW), to the circuit 67. However, the remaining operations to be conducted in the downward sweeping automatic channel selection mode, are substantially the same as those explained above regarding the upward sweeping mode.

When an upward sweeping semi-automatic channel selection mode is selected, a button 64-2 should be turned ON, while, when a downward sweeping semi-automatic channel selection mode is selected, a button 64-1 should be selected. In such a semi-automatic mode, when the button 64-1 or 64-2 is turned OFF, the sweep controlling circuit 62 is suddenly de-energized. At the same time, the lastly received frequency is maintained in the radio receiver circuit.

The flowchart of Fig. 3 will be explained with reference to Fig. 6. At step ⓞ in Fig. 3, one of the preset buttons 70-1~70-7 (corresponding to PB of Fig. 5) is turned ON. A preset-latch circuit 69 detects the ON state which has been initiated by either one of the buttons 70-1 through 70-7 and further this detection is transmitted to the second storage circuit 67 via a line 120. The circuit 67 stores N values corresponding to the respective preset buttons 70-1~70-7 and, accordingly one specified N value is set into the counters 66-1~66-4 (refer to steps ⓡ and ⓤ in Fig. 3). This, the PLL circuit 14 operates based on the specified N value and a corresponding desired radio broadcast can be received. In this case, step ⓟ in Fig. 3 is conducted by means of the LW/MW discriminating circuit 78. The desired broadcasting channels are allotted, in advance, to respective preset

buttons 70-1~70-7 by the initial write operation of data into the circuit 67. When such initial write operation is required, a memory button 68S is turned ON (corresponding to MB of Fig. 5). Then a flip · flop 68 is set by the button 68S, and the circuit 67 is changed to a write operation mode by way of the read/write controlling circuit 71. For example, the manual channel selection knob MT of Fig. 5, is operated, and when a desired radio broadcast is recevied, both the memory button MB 68S and one of the preset buttons 70-1~70-7 are turned ON simultaneously. As a result, the N value of the counters 66-1~66-4, corresponding to the desired radio broadcast, is written into the circuit 67 via the line 108.

The reference numeral 74 represents a band selector which cooperates with switches 75 and 76. The switch 75 corresponds to the band switching button BS of Fig. 5. The status whether or not the LW or the MW is selected by the button 75 is transmitted, via the selector 74, to the LW/MW discriminating circuit 78, the first storage circuit 73 and the second storage circuit 67. In this case, the circuits 67 and 73 are activated at their respective AM storage areas. (Note: The FM mode is not mentioned in the present invention). The switch 76 is used for selecting the LW mode or non-LW mode. If it is apparently expected that the radio receiver is used in a country where no LW radio broadcasting is transmitted, the switch 76 is electrically shorted in advance in the manufacturing factory. Thereby, the LM/MW discriminating circuit 78 is restricted to select only the MW band by a signal applied from the shorted switch 76, via the selector 74 and a line 121.

The reference numeral 80 represents a display panel which corresponds to DP of Fig. 5. The information to be displayed on the panel 80 is given from an operation circuit 77. The circuit 77 can convert the selected N value of the counters 66-1~66-4 into ordinary used digit numbers, for example 155 !kHz1. In this case, since the aforesaid reference frequency $f_r$ (refer to the equation

$$f_{SLL}=N \cdot f_r$$

or

$$f_{SLM}=N \cdot f_r)$$

varies in every country, such as 5 kHz, 9 kHz or 10 kHz, the corresponding reference frequency $f_r$ of each country should be specified by the circuit 73, via a line 122.

The display panel 80 is driven by the clock signal fed from the frequency dividing circuit 61. The circuits 78 and 67 are also driven by the clock signal from the circuit 61. When the flip · flop array circuit 63 is operated, the preset latch circuit 69 must not be operated and vice versa. In order to satisfy such an operational limitation, lines 123 and 124 are introduced between the circuits 63 and 69. That is, either one of the operated circuits (63 or 69) can reset the other circuit (69 or 63) by a reset signal transferred through the respective line 123 or 124. The reason why such an operational limitation is required is that manual channel selection and automatic channel selection must not be performed at the same time.

Further, the reset of the flip · flop 68 is achieved, via the circuit 69 and a line 125, when either one of the preset buttons 70-1 through 70-7 is turned/pressed ON.

As explained above in detail, the technical matters, previously mentioned in paragraphs (1), (2) and (3), can be satisfied by the radio receiver according to the present invention.

**Claims**

1. A radio receiver comprising:

a LW receiving stage (20) including a LW tuning-amplifying circuit (21), a LW local oscillating circuit (22) and a LW mixing circuit (23) for converting a LW receiving signal into a LW intermediate frequency signal;

a MW receiving stage (30) including a MW tuning-amplifying circuit (31), a MW local oscillating circuit (32) and a MW mixing circuit (33) for converting a MW receiving signal into a MW intermediate frequency signal;

an intermediate frequency controlling stage (40) including a detecting circuit (42) and an intermediate frequency signal detecting circuit (41), the detecting circuit (42) receives either one of said LW intermediate frequency signals or MW intermediate frequency signals, produced respectively from said LW receiving stage (20) or MW receiving stage (30), and driving an audio frequency circuit (12), the intermediate frequency signal detecting circuit (41) operates to detect the appearance of an intermediate frequency signal;

a PLL circuit (14) receiving either a LW local oscillating signal or a MW local oscillating signal, produced respectively from said LW receiving stage (20) or said MW receiving stage (30) and feeding an oscillating output signal, which is specified by an externally supplied digital N value, to said LW tuning-amplifying circuit (21) or MW tuning-amplifying circuit (22) via respective feed back paths; and

a digital N value generating circuit (54) producing said digital N value, a first storage means (53, 73) storing both the lowest frequency $f_{Lmin}$ and the highest frequency $f_{Lmax}$ of a LW receiving frequency range and also both the lowest frequency $f_{Mmin}$ and the highest frequency $f_{Mmax}$ of a MW receiving frequency range, a sweep controlling means (62) for increasing or decreasing said digital N value of said digital N value generating circuit (54) by one integer upwardly or downwardly, a comparing means (72) for receiving, at its first comparing input, said digital N value, and for receiving, at its second comparing input, either one of the values $f_{Lmin}$ and $f_{Lmax}$ or either one of the values $f_{Mmin}$ and $f_{Mmax}$,

characterized in that further means are comprised, that is,

a LW/MW discriminating means (78) for receiving said digital N value and discriminating whether the digital N value specifies the LW or the

MW, further designating either said values $f_{Lmin}$ and $f_{Lmax}$ or said values $f_{Mmin}$ and $f_{Mmax}$ according to the result of said discriminating operation, furthermore energizing either said LW receiving stage or said MW receiving stage, a second storage means (55, 67), acting as a storage means for achieving transmission of the initial set of data regarding said frequencies $f_{Lmin}$, $f_{Lmax}$, $f_{Mmin}$ and $f_{Mmax}$ to said digital N value generating circuit (54, 66), for receiving, from said first storage means, the other of said values $f_{Lmin}$ and $f_{Lmax}$ or the other of said values $f_{Mmin}$ and $f_{Mmax}$, which values are stored in said first storage means, but not applied to said comparing means, and

in the sweep controlling means (62), when the upward sweeping of said digital N value is to be conducted, said values $f_{Lmax}$ and $f_{Lmin}$, during the LW band, and said values $f_{Mmax}$ and $f_{Mmin}$, during the MW band, are supplied, from said first storage means (53, 73), respectively to said comparing means (72), at said second comparing input and said second storage means (55, 67), the band switching operation, between the LW band and the MW band, is carried out every time a coincidence signal is produced from said comparing means (72), while also

in the sweep controlling means (62), when the downward sweeping of said digital N value is to be conducted, said values $f_{Lmin}$ and $f_{Lmax}$, during the LW band, and said values $f_{Mmin}$ and $f_{Mmax}$, during the MW band, are supplied, from said first storage means (53, 73), respectively to said comparing means (72), at said second comparing input and said second storage means (55, 67), the band switching operation, between the MW band and the LW band, is carried out every time the coincidence signal is produced from said comparing means (72).

2. A radio receiver as claimed in claim 1, wherein said LW/MW discriminating means (78) is made of a transistor which is turned/switched ON or OFF by two predetermined logic bits produced from said digital N value generating circuit (54, 66).

3. A radio receiver as claimed in claim 1, wherein said LW/MW discriminating means (78) is made of a two-input OR gate which receives two predetermined logic bits produced from said digital N value generating circuit.

4. A radio receiver as claimed in claim 1, wherein said first storage means (73) is made of an ROM.

5. A radio receiver as claimed in claim 1, wherein said second storage means (67) is made of an RAM.

6. A radio receiver as claimed in claim 1, wherein said digital N value generating circuit (66) is made of a programmable up/down counter.

**Revendications**

1. Radiorécepteur comprenant:

un étage de réception de GO (20) comprenant un circuit d'amplification et d'accord de GO (21), un circuit oscillateur local de GO (22) et un circuit mélangeur de GO (23), pour convertir un signal de réception de GO en un signal à fréquence intermédiaire de GO;

un étage de réception de PO (30) comprenant un circuit d'amplification et d'accord de PO (31), un circuit oscillateur local de PO (32) et un circuit mélangeur de PO (33), pour convertir un signal de réception de PO en un signal à fréquence intermédiaire de PO;

un étage de commande de fréquence intermédiaire (40) comprenant un circuit de détection (42) et un circuit de détection de signal à fréquence intermédiaire (41), le circuit de détection (42) recevant soit un des signaux à fréquence intermédiaire de GO, soit un des signaux à fréquence intermédiaire de PO, produits respectivement par l'étage de réception de GO (20) ou par l'étage de réception de PO (30), et pilotant un circuit à audiofréquence (12), le circuit de détection de signal à fréquence intermédiaire (41) détectant l'apparition d'un signal à fréquence intermédiaire; un circuit à boucle de verrouillage de phase (14) recevant soit un signal d'oscillation locale de GO, soit un signal d'oscillation locale de PO, produit respectivement par l'étage de réception de GO (20) ou par l'étage de réception de PO (30), et appliquant au circuit d'amplification et d'accord de GO (21) ou au circuit d'amplification et d'accord de PO (22), par l'intermédiaire de voies à réaction respectives, un signal de sortie d'oscillation qui est spécifié par une valeur numérique N fournie de façon externe; et

un circuit de génération de valeur numérique N (54) produisant ladite valeur numérique N, une première mémoire (53, 73) destinée à enregistrer à la fois la plus basse fréquence $f_{Lmin}$ et la plus haute fréquence $f_{Lmax}$ d'une plage de fréquence de réception de GO, ainsi que la plus basse fréquence $f_{Mmin}$ et la plus haute fréquence $f_{Mmax}$ d'une plage de fréquence de réception de PO, des moyens de commande de balayage (62) destinés à augmenter ou à diminuer d'un nombre entier, en direction ascendante ou descendante, la valeur numérique N du circuit de génération de valeur numérique N(54), des moyens de comparaison (72) destinés à recevoir sur leur première entrée de comparaison la valeur numérique N, et à recevoir sur leur seconde entrée de comparaison l'une des valeurs $f_{Lmin}$ et $f_{Lmax}$, ou l'une des valeurs $f_{Mmin}$ et $f_{Mmax}$,

caractérisé en ce qu'il comprend des moyens supplémentaires, à savoir:

des moyens de discrimination GO/PO (78) destinés à recevoir la valeur numérique N et à déterminer si la valeur numérique N spécifie la gamme GO out la gamme PO, à désigner en outre soit les valeurs $f_{Lmin}$ et $f_{Lmax}$, soit les valeurs $f_{Mmin}$ et $f_{Mmax}$ selon le résultat de l'opération de détermination, et à alimenter de plus soit l'étage de réception de GO, soit l'étage de réception de PO, une seconde mémoire (55, 67), fonctionnant à la manière d'une mémoire destinée à assurer la transmission de l'ensemble initial de données

concernant lesdites fréquences $f_{Lmin}$, $f_{Lmax}$, $f_{Mmin}$ et $f_{Mmax}$ vers le circuit de génération de valeur numérique N (54, 66), pour recevoir, à partir de la première mémoire, l'autre des valeurs $f_{Lmin}$ et $f_{Lmax}$ ou l'autre des valeurs $f_{Mmin}$ et $f_{Mmax}$, ces valeurs étant enregistrées dans la première mémoire, mais non appliquées aux moyens de comparaison, et dans les moyens de commande de balayage (62), lorsque la valeur numérique N doit faire l'objet d'un balayage vers le haut, les valeurs $f_{Lmax}$ et $f_{Lmin}$, pendant le fonctionnement dans la gamme GO, et les valeurs $f_{Mmax}$ et $f_{Mmin}$, pendant le fonctionnement dans la gamme PO, sont respectivement appliquées par la première mémoire (53, 73) à la seconde entrée de comparaison des moyens de comparaison et à la seconde mémoire (55, 67), et l'opération de commutation entre la gamme GO et la gamme PO est accomplie chaque fois que les moyens de comparaison (72) produisent un signal de coïncidence, tandis que également dans les moyens de commande de balayage (62), lorsque la valeur numérique N doit faire l'objet d'un balayage vers le bas, les valeurs $f_{Lmin}$ et $f_{Lmax}$, pendant le fonctionnement dans la gamme GO, et les valeurs $f_{Mmin}$ et $f_{Mmax}$, pendant le fonctionnement dans la gamme PO, sont respectivement appliquées par la première mémoire (53, 73) à la seconde entrée de comparaison des moyens de comparaison (72) et à la seconde mémoire (55, 67), et l'opération de commutation entre la gamme PO et la gamme GO est accomplie chaque fois que les moyens de comparaison (72) produisent le signal de coïncidence.

2. Radiorécepteur selon la revendication 1, dans lequel les moyens de discrimination GO/PO (78) sont constitués par un transistor qui est commuté à l'état conducteur ou bloqué par deux bits logiques prédéterminés produits par le circuit de génération de valeur numérique N (54, 66).

3. Radiorécepteur selon la revendication 1, dans lequel les moyens de discrimination GO/PO (78) sont constitués par une porte OU à deux entrées qui reçoit deux bits logiques prédéterminés produits par le circuit de génération de valeur numérique N.

4. Radiorécepteur selon la revendication 1, dans lequel la première mémoire (73) consiste en une mémoire morte.

5. Radiorécepteur selon la revendication 1, dans lequel la seconde mémoire (67) consiste en une mémoire vive.

6. Radiorécepteur selon la revendication 1, dans lequel le circuit de génération de valeur numérique N (66) est constitué par un compteur à deux sens programmable.

**Patentansprüche**

1. Rundfunkempfänger mit einem LW Empfangsstufe (20) einschließlich einem LW-Abstimm-Verstärkerkreis (21), einem Überlagerungsoszillator (22) und einer LW-Mischstufe (23) zum Umsetzen des LW Empfangssignal in ein LW-Zwischenfrequenzsignal,

mit einer MW Empfangesstufe (30) einschließlich einem MW Abstimm-Verstärkerkreis (31), einem MW Überlagerungsoszillator (32) und einer MW Mischstu fe (23) zum Umsetzen des MW Empgangssignal in ein MW Zwischenfrequenzsignal, mit einer Zwischenfrequenz-Steuerstufe (40) einschließlich einer Demodulatorstufe (42) und einer Schaltung zur Erfassung der Zwischenfrequenzsignale (43), wobei die Demodulatorstufe (42) entweder LW Zwischenfrequenzsignale oder die MW Zwischenfrequenzsignale empfängt, die jeweils von der LW Empfangsstufe (20) oder MW Empfangsstufe (30) erzeugt werden, und weiterhin eine Niederfrequenzschaltung (12) ansteuert und wobei die Schaltung zur Erfassung der Zwischenfrequenzsignale (43) das Auftreten eines Zwischenfrequenzsignales erfaßt;

mit einem PLL-Kreis (14) der entweder ein LW Überlagerungsoszillatorsignal oder ein MW Überlagerungsoszillatorsignal empfängt, die jeweils von der LW Empfangsstufe (20) oder der MW Empfangsstufe (30) erzeigt werden, wobei der PLL Kreis (14) ein oszillierendes Ausgangssignal, das durch einen extern zugeführten digitalen N-Wert bestimmt wird, an den LW Abstimm-Verstärkerkreis (21) oder den MW Abstimm-Verstärkerkreis (31) über entsprechende Rückkopplungsweize liefert; und

mit einer Schaltung zur Erzeugung digitaler N-Werte (54), (66-1 bis 66-4), einem ersten Speicherkreis (53, 73) zur Speicherung der niedrigsten Frequenz $f_{Lmin}$ und der höchsten Frequenz $f_{Lmax}$ eines LW Empfangsbereiches und entsprechend der niedrigen Frequenz $f_{Mmin}$ und der höchsten Frequenz $f_{Mmax}$ eines, MW Empfangsbereiches, mit einem Wobbel-Steuerkreis zum Erhöhen oder Verrringern des von der Schaltung zur Erzeugung digitaler N-Werte (54, 66-1 bis 66-4) gelieferten digitalen N-Wertes um eine ganze Zahl, mit einer Vergleichsschaltung (72), an deren erstem Vergleichseingang der digitale N-Wert und an deren zweitem Vergleichseingang entweder einder der Werte $f_{Lmin}$ und $f_{Lmax}$ oder $f_{Mmin}$ und $f_{Mmax}$ liegen, dadurch gekennzeichnet, daß weitere Einrichtungen vorgesehen sind, nämlich

eine LW/MW Unterscheidungsschaltung (78), die den digitalen N-Wert empfängt und unterscheidet, ob der digitale N-Wert die LW oder die MW angibt, die weiterhin entsprechend dem Ergebnis der Unterschiedung einen der Werte $f_{Lmin}$ und $f_{Lmax}$ oder $f_{Mmin}$ und $f_{Mmax}$ bezeichnet und außerdem die Spannungsversorgung zu der LW Empfangsstufe (20) oder der MW Empfangsstufe (30) steuert;

ein zweiter Speicher (55, 67), der als Zwischenspeicher zum Übertragen des ursprünglichen Datensatzes der Frequenzen $f_{Lmin}$, $f_{Lmax}$, $f_{Mmin}$, $f_{Mmax}$ auf die Schaltung zur Erzeugung digitaler N-Werte (54, 66-1 bis 66-4) dient und der von dem ersten Speicherkreis (53, 73) den anderen der Werte $f_{Lmin}$ und $f_{Lmax}$ oder den anderen der Werte $f_{Mmin}$ und $f_{Mmax}$ erhält, die in dem ersten Speicherkreis (53, 73) gespeichert sind aber nicht der Vergleichsschaltung (72) zugeführt werden, und

daß beim Durchfahren der digitalen N-Werte in Richtung zu höheren Frequenzen hin eine Steuerung durch den Wobbel-Steuerkreis (62) derart erfolgt, daß im LW-Band die $f_{Lmax}$ und $f_{Lmin}$ Werte und im MW-Band die $f_{Mmax}$ und $f_{Mmin}$ Werte von dem ersten Speicherkreis (53, 73) dem zweiten Vergleichseingang der Vergleichsschaltung (72) und dem zweiten Speicher (55, 67) zugeführt werden, wobei die Bandumschaltung zwischen LW-Band und MW-Band immer dann erfolgt, wenn die Vergleichsschaltung (72) ein Übereinstimmungssignal liefert und

daß beim Durchfahren der digitalen N-Werte in Richtung zu niedrigeren Frequenzen hin eine Steuerung durch den Wobbel-Steuerkreis (62) derart erfolgt, daß im LW-Band die $f_{Lmin}$ und $f_{Lmax}$ Werte und im MW-Band die $f_{Mmin}$ und $f_{Mmax}$ Werte von dem ersten Speicherkreis (53, 73) dem zweiten Vergleichseingang der Vergleichsschaltung (72) und dem zweiten Speicher (55, 67) zugeführt werden, wobei die Bandumschaltung zwischen dem MW-Band und dem LW-Band immer dann erfolgt, wenn die Vergleichsschaltung (72) ein Übereinstimmungssignal liefert.

2. Rundfunkempfänger nach Anspruch 1, dadurch gekennzeichnet, daß die LW/MW Unterscheidungsschaltung (78) als Transistor ausgebildet ist, der abhängig von zwei vorbestimmten logischen Bits, die von der Schaltung zur Erzeugung digitaler N-Werte (54, 66) erzeugt werden, leitend ist oder sperrt.

3. Rundfunkempfänger nach Anspruch 1, dadurch gekennzeichnet, daß die LW/MW Unterscheidungsschaltung (78) als ODER-Gatter mit zwei Eingängen ausgebildet ist, das zwei von der Schaltung zur Erzeugung digitaler N-Werte gelieferte bestimmte logische Bits erhält.

4. Rundfunkempfänger nach Anspruch 1, dadurch gekennzeichnet, daß der erste Speicherkreis (73) als ROM ausgebildet ist.

5. Runkfunkempfänger nach Anspruch 1, dadurch gekennzeichnet, daß der zweite Speicher (67) als RAM ausgebildet ist.

6. Rundfunkempfänger nach Anspruch 1, dadurch gekennzeichnet, daß die Schaltung zur Erzeugung digitaler N-Werte (66) als programmierbarer Aufwärts-/Abwärts Zähler ausgebildet ist.

Fig. 1

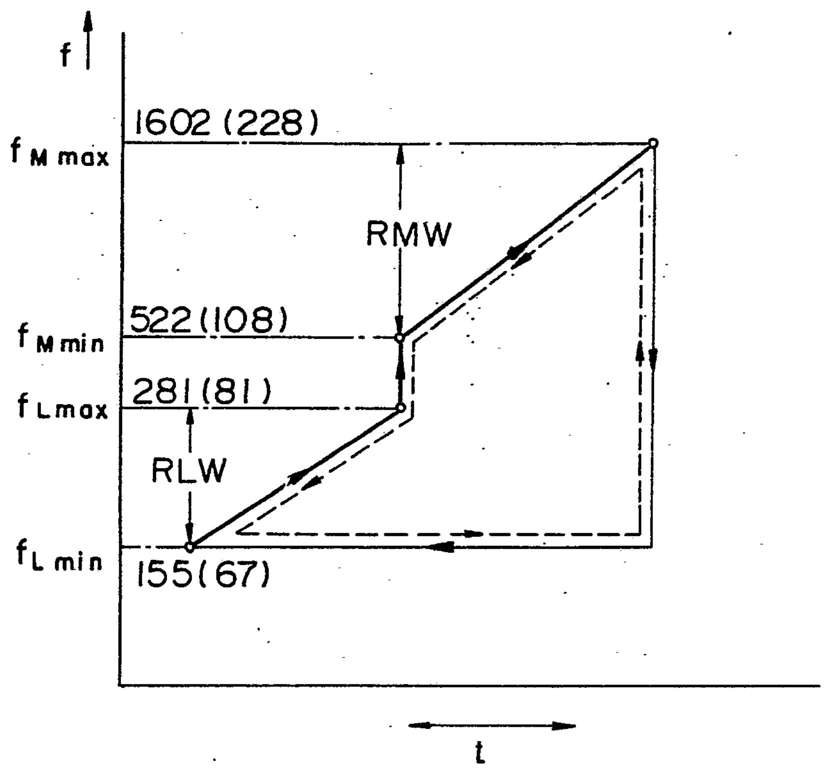
f
1602 (228)
f M max
RMW
522 (108)
f M min
281 (81)
f L max
RLW
f L min
155 (67)
t

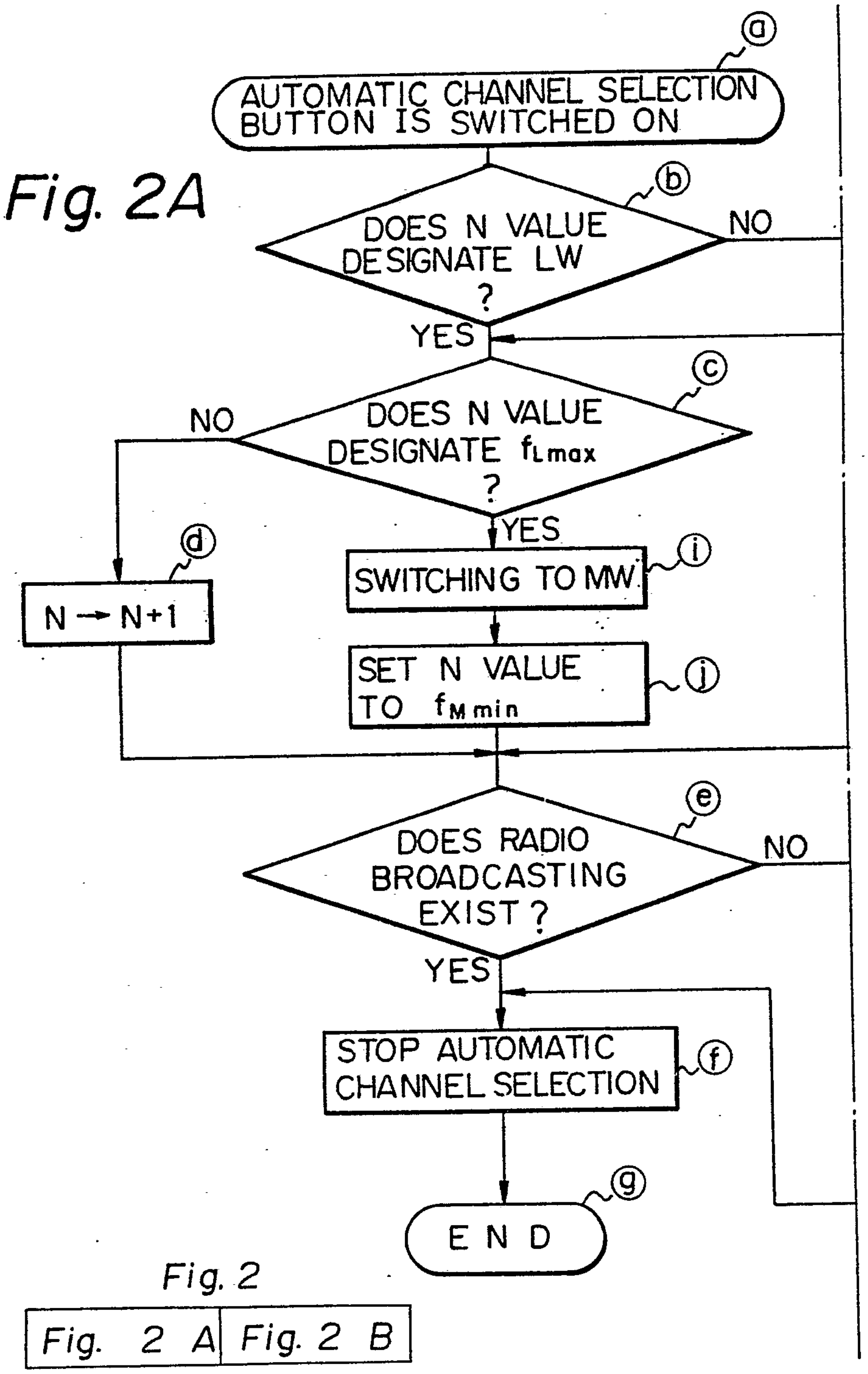


Fig. 2A

Fig. 2

| Fig. 2 A | Fig. 2 B |
|---|---|

Fig. 2B

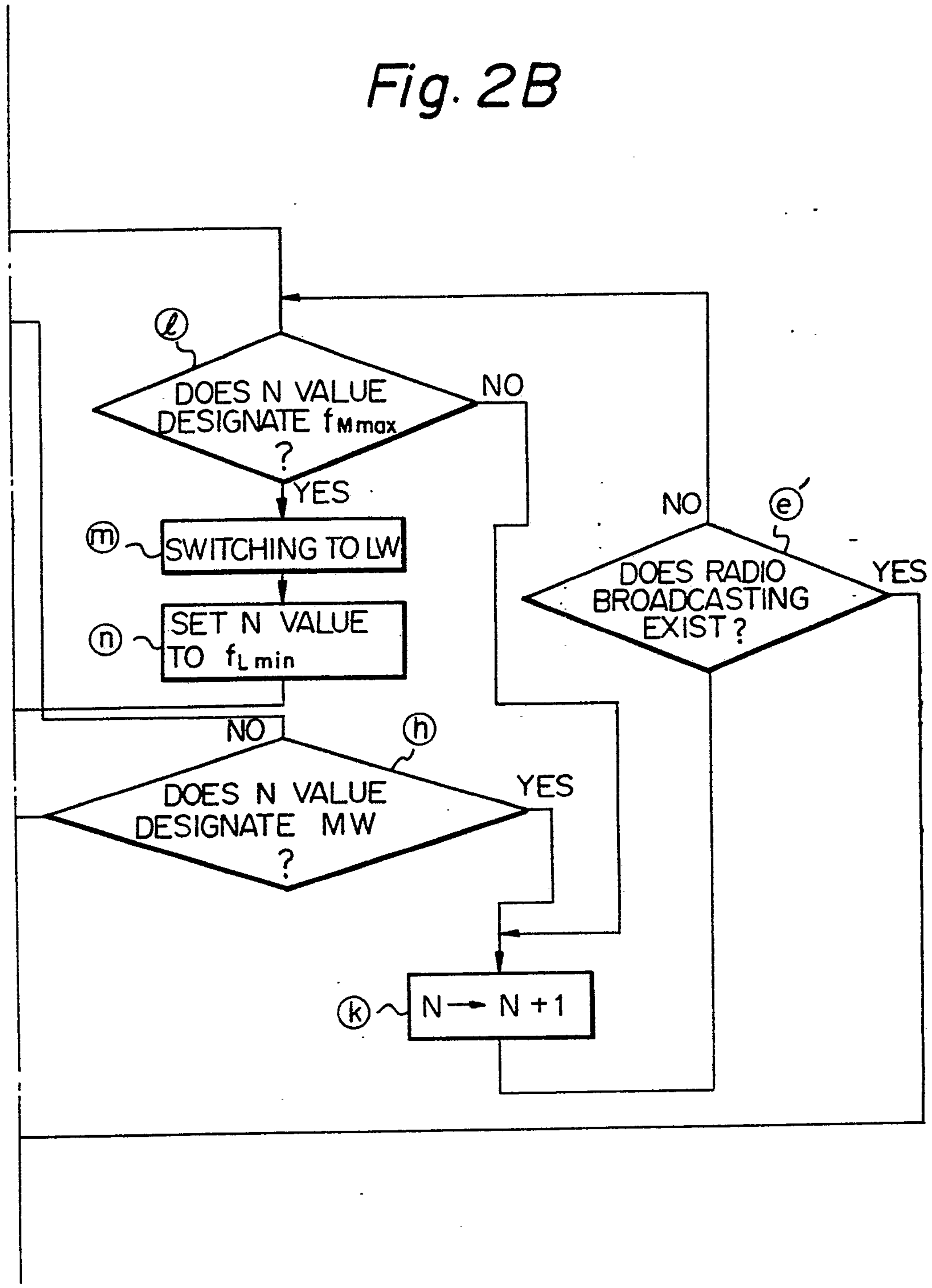

ℓ
DOES N VALUE DESIGNATE $f_{Mmax}$ ?
NO
YES
m
SWITCHING TO LW
n
SET N VALUE TO $f_{L min}$
NO
e
DOES RADIO BROADCASTING EXIST ?
YES
h
DOES N VALUE DESIGNATE MW ?
NO
YES
k
N → N +1

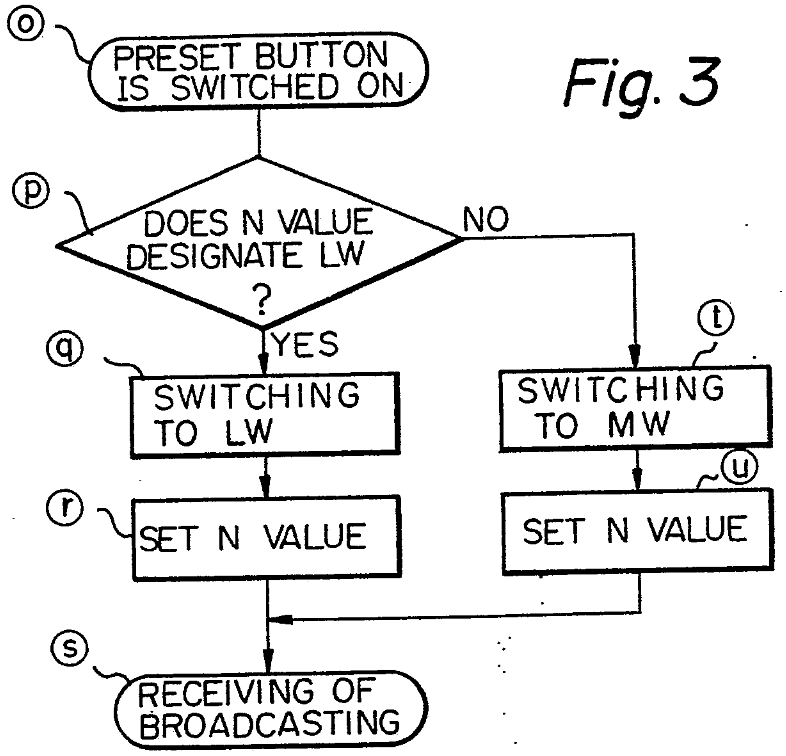
PRESET BUTTON IS SWITCHED ON
DOES N VALUE DESIGNATE LW ?
NO
YES
SWITCHING TO LW
SWITCHING TO MW
SET N VALUE
SET N VALUE
RECEIVING OF BROADCASTING
o
p
q
r
s
t
u

Fig. 3

Fig. 5

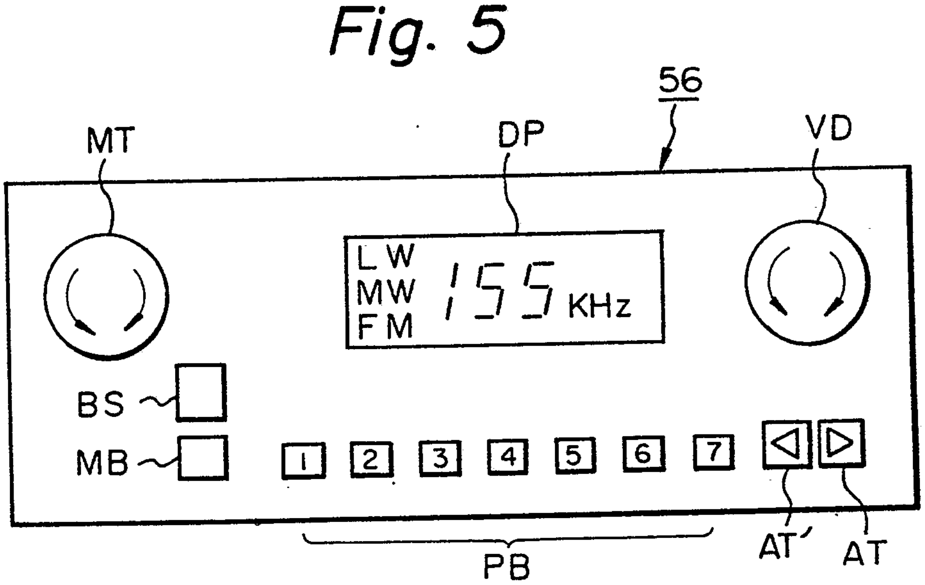
56
MT
DP
VD
LW
MW
FM
155 KHz
BS
MB
1
2
3
4
5
6
7
PB
AT'
AT

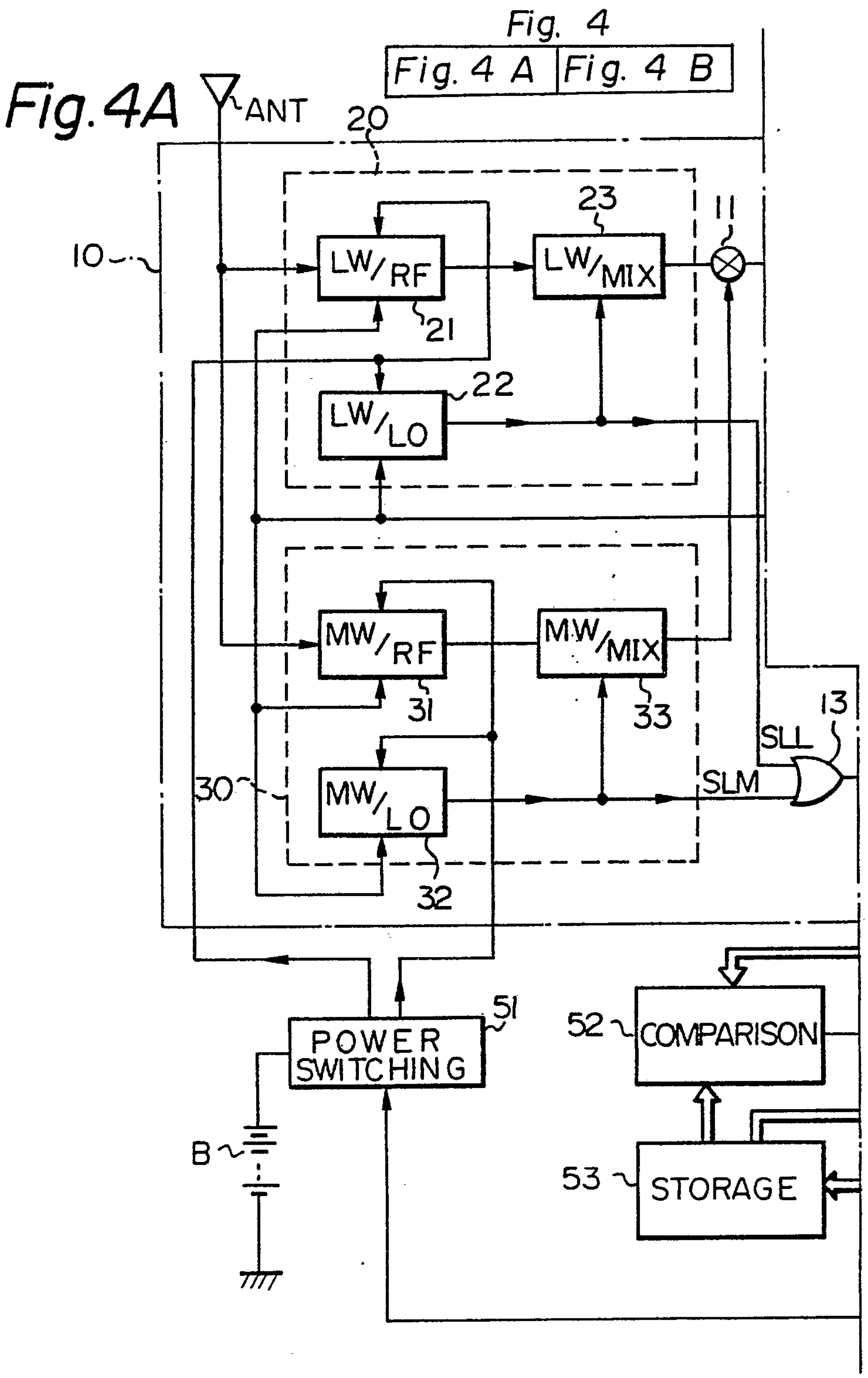
Fig. 4
Fig. 4 A
Fig. 4 B
Fig. 4A
ANT
20
10
LW/RF
21
23
LW/MIX
11
LW/LO
22
MW/RF
31
MW/MIX
33
MW/LO
32
30
13
SLL
SLM
POWER SWITCHING
51
B
52
COMPARISON
53
STORAGE

Fig. 4B

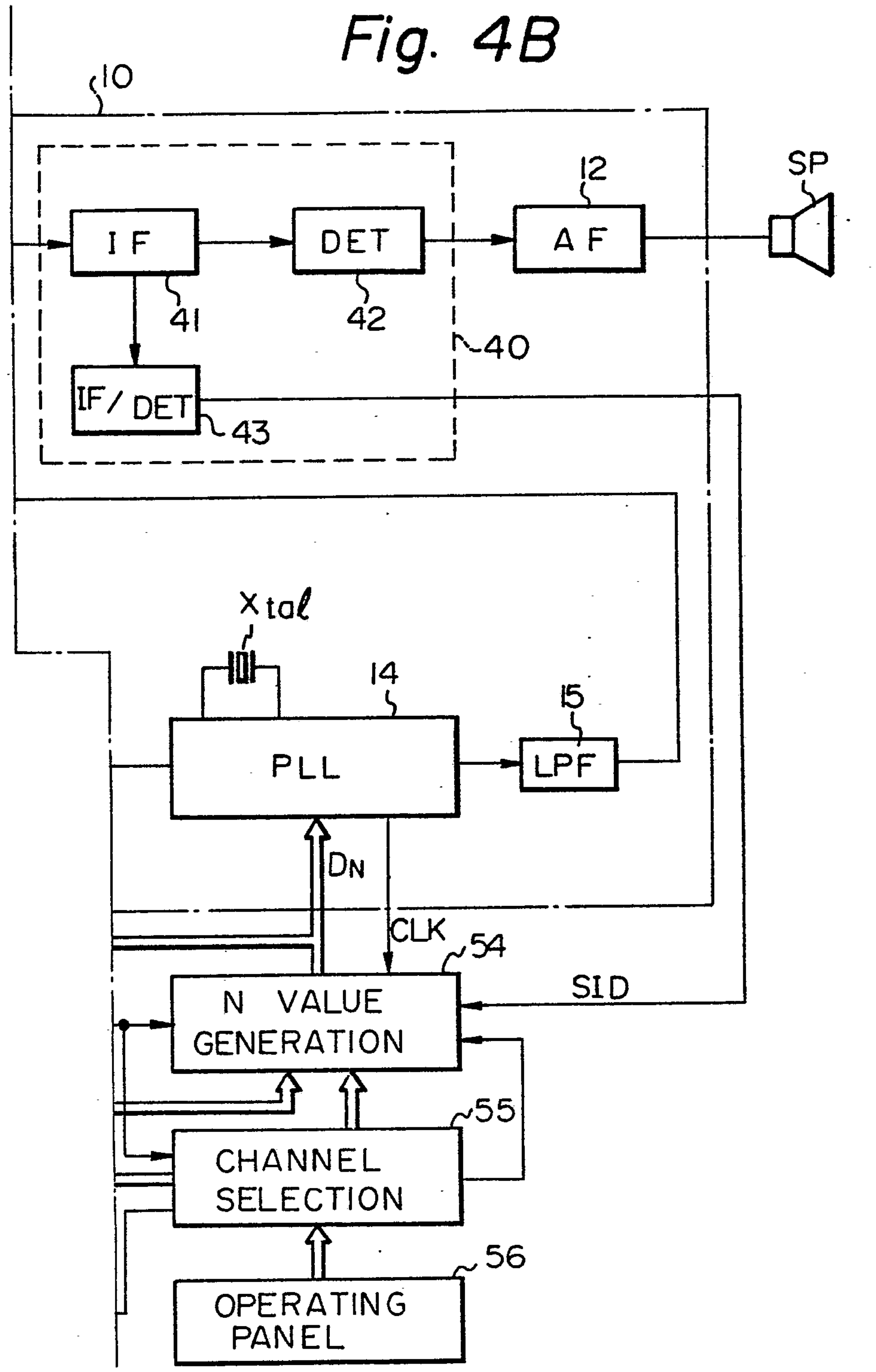
10
IF
DET
AF
12
SP
41
42
40
IF/DET
43
Xtal
14
PLL
15
LPF
DN
CLK
54
N VALUE GENERATION
SID
55
CHANNEL SELECTION
56
OPERATING PANEL

Fig. 6

| Fig. 6A | Fig. 6B | Fig. 6C |
|---|---|---|

Fig. 6A

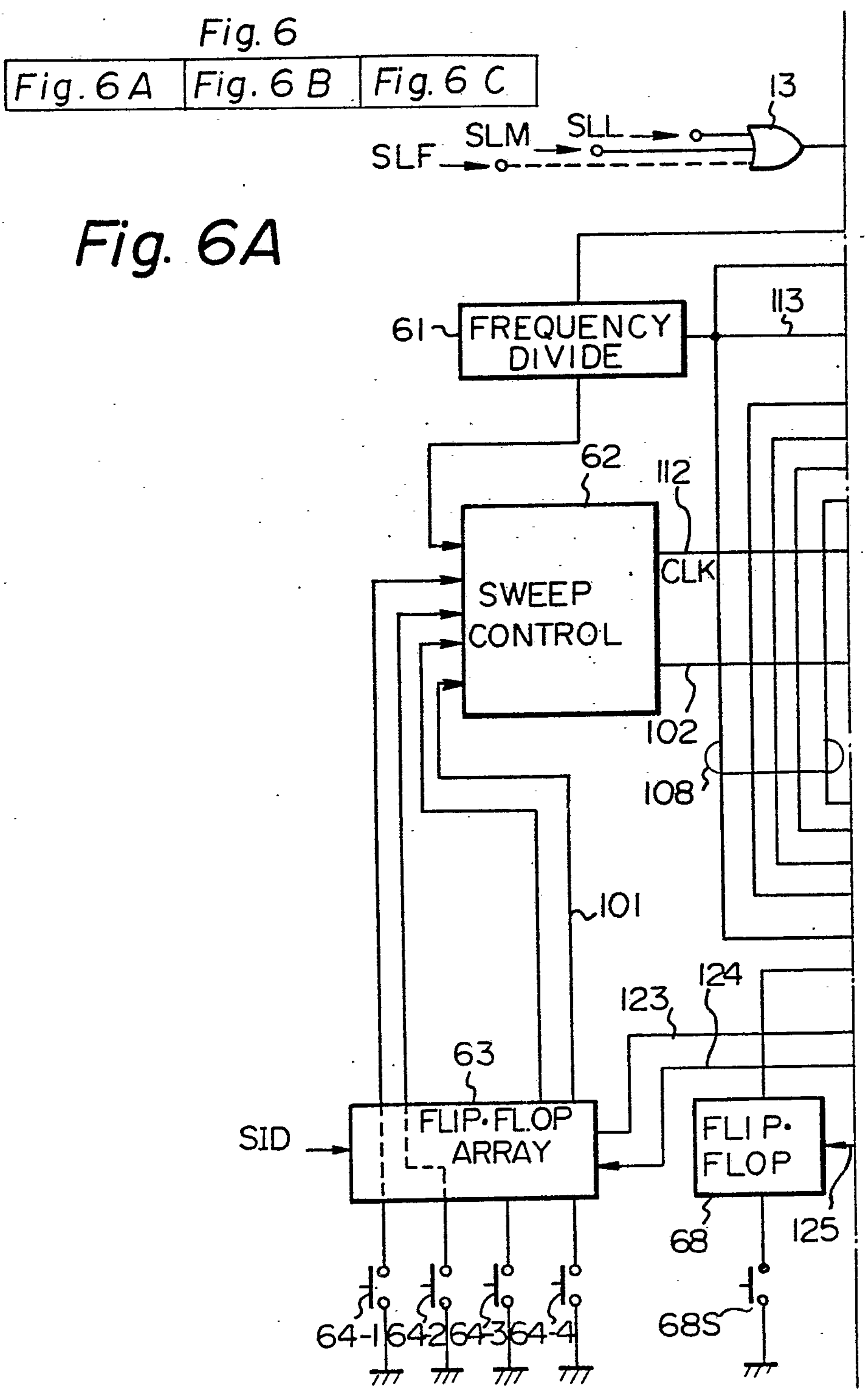

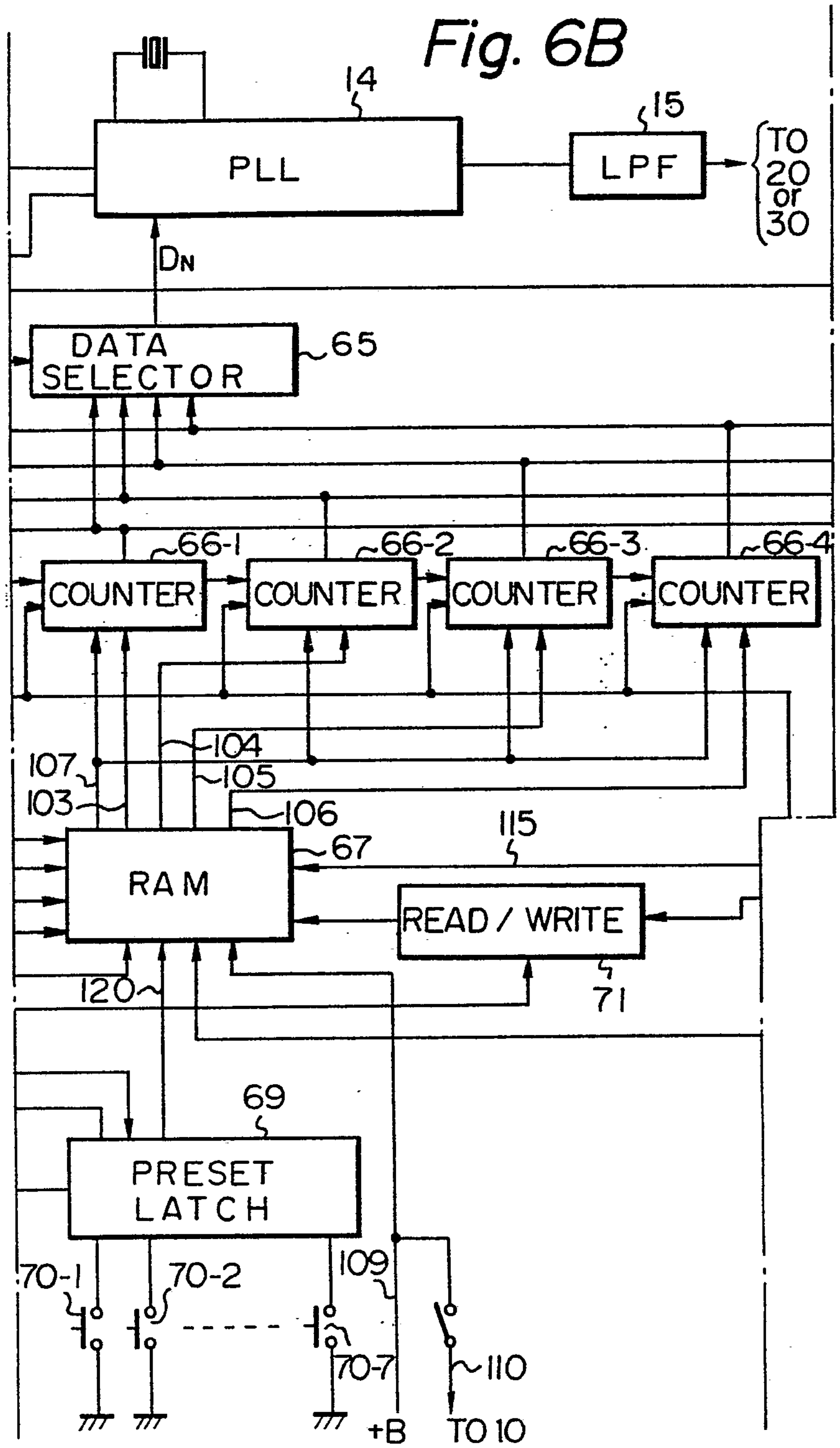
Fig. 6B
14
PLL
15
LPF
TO 20 or 30
DN
DATA SELECTOR
65
66-1
66-2
66-3
66-4
COUNTER
COUNTER
COUNTER
COUNTER
107
103
104
105
106
RAM
67
115
READ / WRITE
71
120
69
PRESET LATCH
70-1
70-2
109
70-7
110
+B
TO 10

Fig. 6C

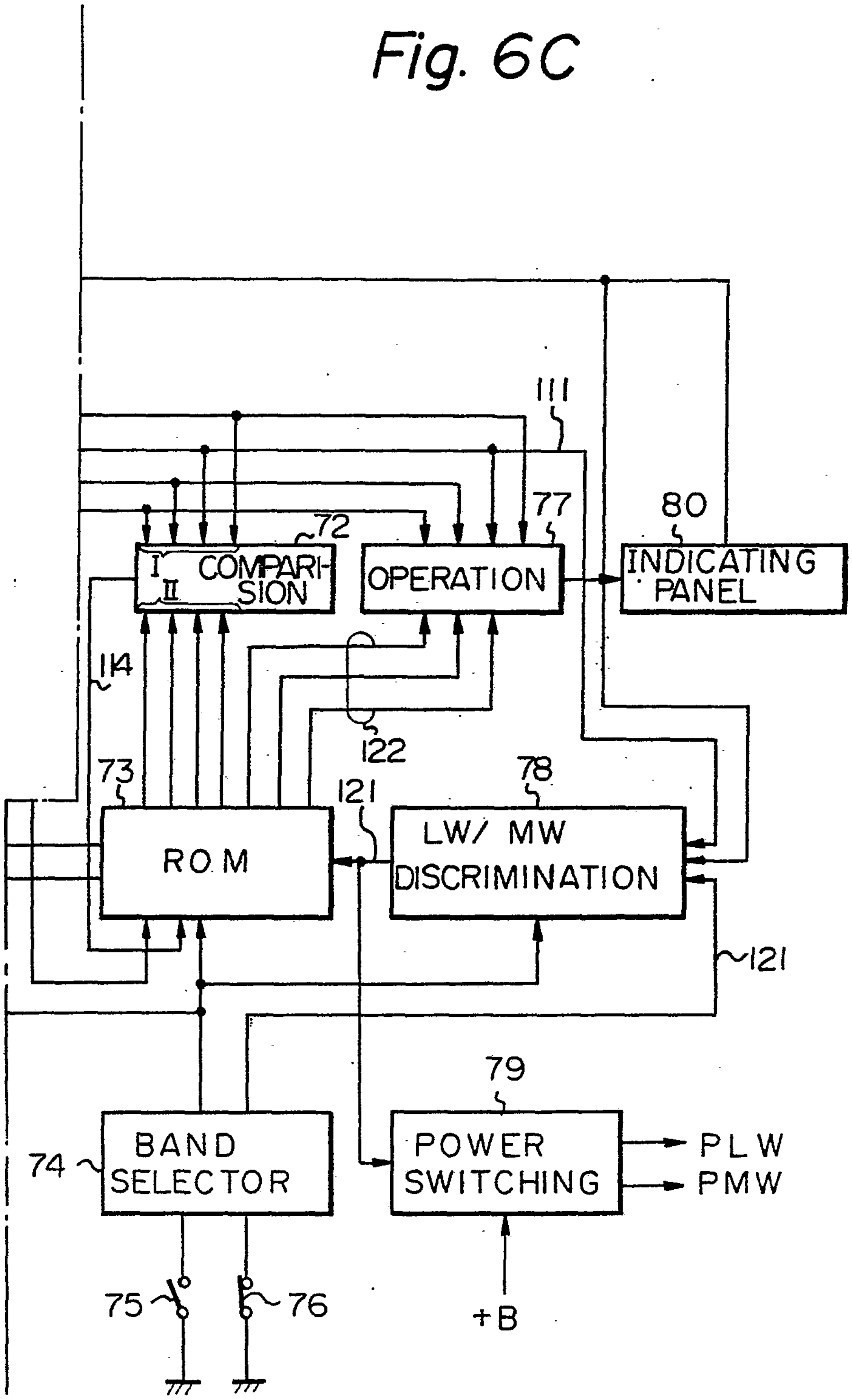
111
72
I
II
COMPARI-
SION
77
OPERATION
80
INDICATING
PANEL
114
122
73
121
78
RO.M
LW/ MW
DISCRIMINATION
121
79
74
BAND
SELECTOR
POWER
SWITCHING
PLW
PMW
75
76
+B